Europäisches Patentamt

(19) European Patent Office

Office européen des brevets

(11) Veröffentlichungsnummer: **0 048 017**
B1

(12) **EUROPÄISCHE PATENTSCHRIFT**

(45) Veröffentlichungstag der Patentschrift:
21.11.84

(51) Int. Cl.³: **G 01 R 1/20,** G 01 F 23/06,
G 01 D 5/16

(21) Anmeldenummer: **81107246.1**

(22) Anmeldetag: **15.09.81**

(54) **Messverfahren für Messwerte von Kraftfahrzeugen.**

(30) Priorität: **17.09.80 DE 3034974**

(43) Veröffentlichungstag der Anmeldung:
**24.03.82 Patentblatt 82/12**

(45) Bekanntmachung des Hinweises auf die Patenterteilung:
**21.11.84 Patentblatt 84/47**

(84) Benannte Vertragsstaaten:
**DE FR GB IT**

(56) Entgegenhaltungen:
**DE - A - 2 325 913**
**US - A - 3 334 339**
**US - A - 3 335 414**

(73) Patentinhaber: **BAYERISCHE MOTOREN WERKE
Aktiengesellschaft, Postfach 40 02 40 Petuelring 130,
D-8000 München 40 (DE)**

(72) Erfinder: **Haberl, Josef, Dipl.-Phys, Jupiterweg 7,
D-8011 Aschheim (DE)**

(74) Vertreter: **Bullwein, Fritz Bayerische Motoren Werke
Aktiengesellschaft, Postfach 40 02 40 -
AJ-23 Petuelring 130, D-8000 München 40 (DE)**

BUNDESDRUCKEREI BERLIN

## Beschreibung

Die Erfindung bezieht sich auf ein Meßverfahren für Meßwerte von Kraftfahrzeugen, mit einem Widerstandsgeber, mit einem damit in Reihe geschalteten Drehspul-Anzeigegerät und mit einem am Widerstandsgeber angeschlossenen Meßwertaufnehmer.

Der bekannteste derartige Meßwert ist die Kraftstoff-Vorratsmenge, die durch einen als Tauchrohrgeber ausgebildeten Widerstandsgeber gemessen wird. Die Drehspul-Anzeigegeräte können beispielsweise Differenzspannungs-Anzeigevorrichtungen, wie sie beispielsweise aus der DE-A-2 325 913 bekannt sind und bei denen der Widerstandsgeber parallel zu einer der beiden Spulen angeordnet ist, oder beispielsweise auch Kreuzspulinstrumente mit zwei Drehspulen sein, bei denen der Widerstandsgeber in einer Meßbrücke angeordnet ist. Der Meßwertaufnehmer schließlich kann beispielsweise Teil eines sogenannten Bord-Computers sein, der beispielsweise aus dem gemessenen Kraftstoff-Vorrat unter Zugrundelegung des momentanen Kraftstoffverbrauchs des Kraftfahrzeugs die Reichweite bestimmt und anzeigt.

Die aus der genannten DE-A-2 325 913 bekannte Anzeigevorrichtung wird zudem von der Versorgungsspannungsquelle abgeschaltet, wenn durch Beschleunigen, Verzögern, Kurvenfahrt oder Berg- oder Talfahrt des Fahrzeugs eine Fehlanzeige hervorgerufen werden würde.

Bei einem bekannten derartigen Meßverfahren ist der Meßwertaufnehmer ständig an der Verbindung zwischen dem Widerstandsgeber und dem Drehspul-Anzeigegerät angeschlossen und bestimmt das Verhältnis der an dieser Stelle abfallenden Spannung zu der Bordnetzspannung (US-A-3 334 339). Anhand einer Kennlinie läßt sich dann aus diesem Verhältnis der Meßwert bestimmen.

Infolge von Fertigungstoleranzen kann der Widerstandswert der Drehspule innerhalb einer Lieferung um bis zu 20% schwanken. Zwar läßt sich durch einen in der Regel eingebauten veränderbaren Widerstand das Anzeigegerät abgleichen, so daß der von diesem angezeigte Meßwert den tatsächlichen Verhältnissen entspricht. Für den Meßwertaufnehmer hat diese Streuung des Drehspul-Widerstandes jedoch eine erhebliche Abweichung von der Kennlinie zur Folge, so daß das gebildete Verhältnis erheblich von der Kennlinie abweicht. Damit sind auch die ggf. anschließend durchgeführten Berechnungen, im Falle der Kraftstoff-Vorratsmenge die Berechnung beispielsweise der voraussichtlichen Reichweite, mit einem erheblichen Fehler behaftet.

Der Erfindung liegt die Aufgabe zugrunde, ein Meßverfahren der eingangs genannten Art zu schaffen, bei dem der dem Meßwertaufnehmer zugeführte Meßwert frei von Einflüssen des Drehspul-Anzeigegerätes ist.

Die Erfindung löst diese Aufgabe für das eingangs beschriebene Meßverfahren dadurch, daß der Meßwertaufnehmer nur kurzzeitig am Widerstandsgeber angeschlossen wird und daß das Anzeigegerät während dieser Zeit vom Widerstandsgeber getrennt wird.

Anstelle der parallelen Verwendung des Widerstandsgebers für das Drehspul-Anzeigegerät und den Meßwertaufnehmer tritt die abwechselnde Verbindung des Widerstandsgebers mit dem Drehspul-Anzeigegerät und dem Meßwertaufnehmer. Dadurch wird jede Kopplung zwischen Drehspul-Anzeigegerät und Meßwertaufnehmer ausgeschlossen. Fertigungstoleranzen des Drehspul-Anzeigegerätes gehen damit nicht in den Meßwertaufnehmer ein.

Der vom Widerstandsgeber gelieferte Meßwert kann beispielsweise aus einer Spannungsmessung bestimmt werden. Hierzu wird dem Meßwertaufnehmer die bei konstantem Strom am Widerstandsgeber abfallende Spannung zugeführt. Der Meßwertaufnehmer ist somit auch frei von Schwankungen der Betriebsspannung. Alternativ dazu kann der Meßwert auch durch eine Bestimmung des durch den Widerstandsgeber bei konstanter angelegter Spannung fließenden Stromes bestimmt werden.

Der Meßwertaufnehmer kann in regelmäßigen Abständen am Widerstandsgeber angeschlossen werden. Der Abstand kann zeit- oder wegstreckenabhängig sein. In beiden Fällen sind die vom Meßwertaufnehmer gelieferten Werte, sofern die Abstände hinreichend klein sind, stets zumindest annähernd auf dem aktuellen Stand.

Bei einer weiteren Ausgestaltung der Erfindung kann der Meßwert im Meßwertaufnehmer bis zur nächsten Aufnahme gespeichert werden. Wird der Meßwert, wie beschrieben, in mehrfacher Weise weiterverarbeitet, so entfallen dadurch separate Speicher für die einzelnen Verarbeitungszweige, da jeder Zweig ständig aus dem gemeinsamen Speicher bedient werden kann.

Um zu vermeiden, daß die Anzeige des Drehspul-Anzeigegerätes während der Trennung vom Widerstandsgeber zurückgeht, wird das Gerät während dieser Zeit gepuffert. Als besonders einfacher Puffer kann ein Kondensator dienen, der entsprechend der Einstellung des Widerstandsgebers aufgeladen ist. Dieser ersetzt somit den Widerstandsgeber während dessen Trennung vom Drehspul-Anzeigegerät.

Eine schaltungstechnisch besonders einfache Realisierung des Meßverfahrens besteht darin, daß die Trennung bzw. Verbindung von Drehspul-Anzeigegerät und Widerstandsgeber, die Zuschaltung bzw. Abtrennung des Kondensators und die Verbindung bzw. Trennung von Meßwertaufnehmer und Widerstandsgeber durch einen Schalter vorgenommen werden.

Die Erfindung ist anhand eines in der Zeichnung dargestellten Ausführungsbeispiels erläutert. Es zeigt

Fig. 1 eine bekannte Schaltanordnung für ein Meßverfahren für Kraftfahrzeuge, bei dem ein Widerstandsgeber gleichzeitig mit einem Drehspul-Anzeigegerät und einem Meßwertaufnehmer in Reihe geschaltet ist, und

Fig. 2 eine Schaltanordnung für das erfindungsgemäße Meßverfahren.

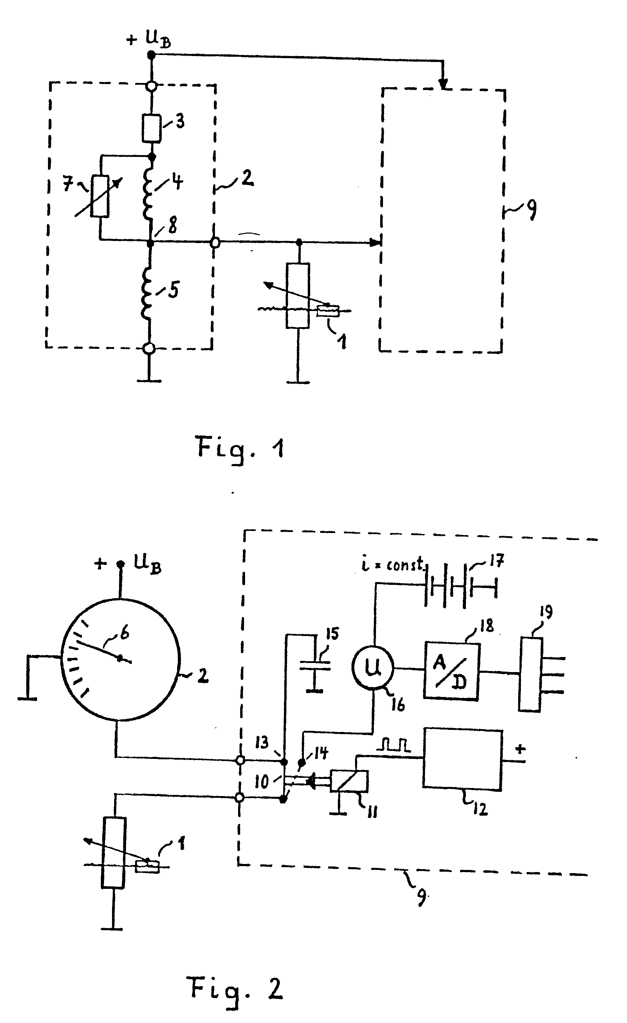

Eine Schaltanordnung für ein Meßverfahren zur Bestimmung von Meßwerten, die beispielsweise vom Vorrat oder von der Temperatur einer Betriebsflüssigkeit, wie Kraftstoff, Motoröl, Getriebeöl, Waschwasser oder Bremsflüssigkeit abhängig sind, enthält einen beispielsweise als Tauchrohrgeber ausgebildeten Widerstandsgeber 1, der in Reihe mit einem als Differenzspannungs-Meßwerk ausgebildeten Drehspul-Anzeigegerät 2 geschaltet ist. Das Anzeigegerät 2 ist an der Betriebsspannung $U_B$ (+) angeschlossen und enthält einen konstanten Widerstand 3 sowie zwei Spulen 4 und 5, von denen die Spule 5 auf Masse geschaltet ist. Die Spulen 4 und 5 sind derart gewickelt und angeordnet, daß die von ihnen erzeugten Magnetfelder gegeneinander gerichtet sind, und beeinflussen die Winkelstellung eines in Fig. 2 dargestellten Zeigers 6, der sich entsprechend dem Magnetfeld einstellt, das aus den von den Spulen 4 und 5 erzeugten Magnetfeldern resultiert. Parallel zur Spule 4 liegt ein Abgleichwiderstand 7, mit dem die Stellung des Zeigers 6 justiert werden kann. Der Widerstandsgeber 1 ist an der Verbindung 8 der beiden Spulen 4 und 5 angeschlossen.

Ebenfalls an der Verbindung 8 ist ein im einzelnen nicht dargestellter Bord-Computer 9 angeschlossen, der aus nicht dargestellten Rechenund Anzeigeeinheiten besteht und der als Meßwertaufnehmer dient. Der Bord-Computer berechnet das Verhältnis der an der Verbindung 8 abfallenden Spannung zu der Spannung $U_B$ und bestimmt daraus beispielsweise den Kraftstoffvorrat des Kraftfahrzeugs.

Infolge von Fertigungstoleranzen können die Widerstandswerte der Spulen 4 und 5 bis zu einem Drittel von einem vorgegebenen Normalwert abweichen. Diese Abweichungen lassen sich mit Hilfe des Abgleichwiderstandes 7 so kompensieren, daß der Zeiger 6 unabhängig von diesen Fertigungstoleranzen dem Widerstandswert des Widerstandsgebers 1 entspricht. Für den Bord-Computer 9 bedeutet dies jedoch eine erhebliche Abweichung des berechneten Verhältnisses und damit der auf dieser Berechnung aufbauenden weiteren Meßwert-Verarbeitung.

Bei der Schaltanordnung nach Fig. 2 ist in die Verbindung zwischen dem Widerstandsgeber 1 und dem Anzeigegerät 2 ein relaisgesteuerter Schalter 10 eingebaut, dessen Spule 11 in zeitlich regelmäßigen Abständen erregt ist. Hierzu dient ein Frequenzuntersetzer 12, der am Ausgang eines nicht dargestellten Taktgebers angeschlossen ist.

Der Schalter 10 schaltet zwischen einem Ruhekontakt 13 und einem Arbeitskontakt 14 um. Am Ruhekontakt 13 ist ein Kondensator 15 angeschlossen. Der Arbeitskontakt 14 liegt in Reihe mit einem Spannungsmesser 16 und einer Konstant-Stromquelle 17.

Bei nicht erregter Spule 11 ist der Widerstandsgeber 1 mit dem Anzeigegerät 2 in Reihe geschaltet. Die Stellung des Zeigers 6 entspricht der Einstellung des Widerstandsgebers 1. Wird die Spule 11 hingegen kurzzeitig, z. B. für 1 ms durch den Frequenzuntersetzer 12 erregt, so wird die Verbindung zwischen dem Widerstandsgeber 1 und dem Anzeigegerät 2 für diese Zeit unterbrochen. Das Anzeigegerät 2 ist nunmehr mit dem Kondensator 15 in Reihe geschaltet, der entsprechend der Einstellung des Widerstandsgebers 1 geladen ist. Der Kondensator 15 wirkt als Puffer und verhindert ein Zurückgehen des Zeigers 6, so daß die Trennung zwischen Anzeigegerät 2 und Widerstandsgeber 1 am Anzeigegerät 2 nicht bemerkt wird.

Hierzu ist die Kapazität C des Kondensators 15 unter Berücksichtigung des Widerstands R der Spule 5 so gewählt, daß die resultierende Zeitkonstante $\tau = R \cdot C$ lang genug — z. B. hier 10 ms — ist, um ein sichtbares Zurückgehen des Zeigers 6 während der Umschaltzeit auf Kontakt 14 zu vermeiden.

Der Widerstandsgeber 1 ist nunmehr in Reihe mit der Konstant-Stromquelle 17 geschaltet. Der Spannungsmesser 16 bestimmt die am Widerstandsgeber 1 abfallende Spannung und führt diesen exakten, durch mögliche Fertigungstoleranzen des Anzeigeräts 2 nicht beeinflußten Meßwert, beispielsweise über einen Analog/Digital-Wandler 18 weiteren Rechen- und Anzeigeeinrichtungen des Bord-Computers zu. Die so gewonnenen Meßwerte sind unabhängig von der Bordnetzspannung $U_B$ und entsprechen exakt der Einstellung des Widerstandsgebers 1. Das Ausgangssignal des Analog/Digital-Wandlers 18 wird vor der weiteren Verarbeitung in einem Speicher 19 aufgenommen und darin festgehalten.

Nach Ablauf der kurzen Zeit gelangt der Schalter 10 wieder in die eingezeichnete Ruhelage, in der wieder die Verbindung zwischen Widerstandsgeber 1 und Anzeigegerät 2 hergestellt und die Verbindung zwischen Widerstandsgeber 1 und Konstant-Stromquelle 17 unterbrochen wird. Der Kondensator 15 wird wieder entsprechend der Einstellung des Widerstandsgebers 1 aufgeladen. Das Anzeigegerät 2 stellt sich entsprechend dieser Einstellung ein. Bis zur erneuten Einschaltung der Konstant-Stromquelle 17 werden die Rechen- und Anzeigeeinrichtungen des Bord-Computers 9 aus dem Speicher 19 mit dem zuletzt aufgenommenen Meßwert versorgt.

Durch die Entkopplung von Anzeigegerät 2 und Bord-Computer 9 wird eine Beeinflussung des Bord-Computers 9 durch das Anzeigegerät 2 vermieden. Der Bord-Computer 9 erhält den vom Widerstandsgeber 1 gelieferten »reinen« Meßwert, während gleichzeitig eine durch die Trennung von Anzeigegerät 2 und Widerstandsgeber 1 bedingte mögliche Veränderung der Anzeige dieses Geräts verhindert wird.

## Patentansprüche

1. Meßverfahren für Meßwerte von Kraftfahrzeugen, mit einem Widerstandsgeber (1), mit einem damit in Reihe geschalteten Drehspul-Anzeigegerät (2), und mit einem am Widerstandsgeber (1) angeschlossenen Meßwertaufnehmer (9), dadurch gekennzeichnet, daß der Meßwertaufnehmer (9) nur kurzzeitig am Widerstandsgeber (1) angeschlossen wird und daß das Anzeigegerät (2) während dieser Zeit vom Widerstandsgeber (1) getrennt wird.

2. Meßverfahren nach Anspruch 1, dadurch gekennzeichnet, daß dem Meßwertaufnehmer (9) die bei konstantem Strom am Widerstandsgeber (1) abfallende Spannung zugeführt wird.

3. Meßverfahren nach Anspruch 1 oder 2, dadurch gekennzeichnet, daß der Meßwertaufnehmer (9) in regelmäßigen Abständen am Widerstandsgeber (1) angeschlossen wird.

4. Meßverfahren nach einem der Ansprüche 1 bis 3, dadurch gekennzeichnet, daß der Meßwert im Meßwertaufnehmer (9) bis zur nächsten Aufnahme gespeichert wird.

5. Meßverfahren nach einem der Ansprüche 1 bis 4, dadurch gekennzeichnet, daß das Anzeigegerät (2) während der Trennung vom Widerstandsgeber (1) gepuffert wird.

6. Meßverfahren nach Anspruch 5, dadurch gekennzeichnet, daß als Puffer ein Kondensator (15) dient, der entsprechend der Einstellung des Widerstandsgebers (1) aufgeladen ist.

7. Meßverfahren nach Anspruch 6, dadurch gekennzeichnet, daß die Trennung bzw. Verbindung von Drehspul-Anzeigegerät (2) und Widerstandsgeber (1), die Zuschaltung bzw. Abtrennung des Kondensators (15) und die Verbindung bzw. Trennung von Meßwertaufnehmer (9) und Widerstandsgeber (1) durch einen Schalter (10) vorgenommen werden.

## Claims

1. A method of measuring the parameters of vehicles, with a resistance transmitter (1), with a moving coil indicating instrument (2) connected in series therewith, and with a measured-value receiver (9) connected to the resistance transmitter (1), characterized in that the measured-value receiver (9) is connected only briefly to the resistance transmitter (1), and in that the indicating instrument (2) is separated from the resistance transmitter (1) during this time.

2. A method of measuring according to claim 1, characterized in that the voltage, diminishing when the current at the resistance transmitter (1) is constant, is applied to the measured-value receiver (9).

3. A method of measuring according to claim 1 or 2, characterized in that the measured-value receiver (9) is connected to the resistance transmitter (1) at regular intervals.

4. A method of measuring according to any one of claims 1 to 3, characterized in that the measured-value is stored in the measured-value receiver (9) until the next pick-up.

5. A method of measuring according to any one of claims 1 to 4, characterized in that the indicating instrument (2) is buffered during separation from the resistance transmitter (1).

6. A method of measuring according to claim 5, characterized in that a condenser (15), which is charged according to the setting of the resistance transmitter (1), is used as a buffer.

7. A method of measuring according to claim 6, characterized in that the separation and connection of the moving coil indicating instrument (2) and the resistance transmitter (1), the connection and separation of the condenser (15) and the connection and separation of the measured-value receiver (9) and the resistance transmitter (1) are carried out by a switch (10).

## Revendications

1. Procédé de mesure pour mesurer des paramètres électriques d'une voiture automobile, avec un indicateur de résistance (1), auquel est connecté en série un appareil indicateur à bobine rotative (2), et avec un capteur de valeur de mesure (9) raccordé à l'indicateur de résistance (1), procédé caractérisé en ce que le capteur de valeur de mesure (9) n'est raccordé qu'un court instant à l'indicateur de résistance (1) et que, pendant ce temps, l'appareil indicateur (2) est séparé de l'indicateur de résistance (1).

2. Procédé de mesure suivant la revendication 1, caractérisé en ce que, au capteur de valeur de mesure (9), est amenée la chute de tension produite sur l'indicateur de résistance (1) avec courant constant.

3. Procédé de mesure suivant l'une des revendications 1 ou 2, caractérisé en ce que le capteur de valeur de mesure (9) est raccordé à l'indicateur de résistance (1) à des intervalles de temps réguliers.

4. Procédé de mesure suivant l'une quelconque des revendications 1 à 3, caractérisé en ce que la valeur de mesure dans le capteur de valeur de mesure (9) est conservé en mémoire jusqu'à la réception suivante.

5. Procédé de mesure suivant l'une quelconque des revendications 1 à 4, caractérisé en ce que l'appareil indicateur (2) est amorti et étouffé pendant la séparation d'avec l'indicateur de résistance (1).

6. Appareil de mesure suivant la revendication 5, caractérisé en ce que, comme amortisseur, on utilise un condensateur (15) qui est chargé en correspondance avec la position de l'indicateur de résistance (1).

7. Appareil de mesure suivant la revendication 6, caractérisé en ce que la séparation et la liaison de l'appareil indicateur à bobine rotative (2) et de l'indicateur de résistance (1), ainsi que la liaison et la séparation du condensateur (16), ainsi que la liaison et la séparation du capteur de valeur de mesure (9) et de l'indicateur de résistance (1), sont reliées au moyen d'un contacteur (10).

**Fig. 1**

**Fig. 2**